# FASCICULE DE BREVET EUROPEEN

(11) **EP 3 503 699 B1**
(45) Date de publication et mention de la délivrance du brevet: **26.01.2022**
(21) Numéro de dépôt: 18212421.4
(22) Date de dépôt: 13.12.2018
(51) Int. Cl.: H05K 7/14

(54) **SYSTÈME D'INTERCONNEXION DE CARTES ÉLECTRONIQUES ET ARMOIRE DE CALCUL INFORMATIQUE COMPRENANT UN TEL SYSTÈME**
VERBINDUNGSSYSTEM VON ELEKTRONISCHEN KARTEN, UND GEHÄUSE FÜR COMPUTERBERECHNUNGEN, DAS EIN SOLCHES SYSTEM UMFASST
INTERCONNECTION SYSTEM FOR ELECTRONIC CARDS AND COMPUTER CALCULATION CABINET COMPRISING SUCH A SYSTEM

(30) Priorité: 22.12.2017 FR 1763108
(43) Date de publication de la demande: 26.06.2019
(73) Titulaire: Bull SAS, 78340 Les Clayes-sous-Bois (FR)
(72) Inventeur: BROWN, Paul, 78000 Versailles (FR)
(74) Mandataire: Novagraaf Technologies

(56) Documents cités:
- EP-A1- 3 139 447
- US-A1- 2015 116 923
- US-A1- 2015 296 652
- US-A1- 2016 036 727

## Description

La présente invention concerne un système d'interconnexion de cartes électroniques destiné à être intégré dans une armoire de calcul informatique, et une armoire de calcul informatique comprenant un tel système. Elle trouve notamment une application à l'interconnexion de cartes électroniques dans des armoires de calcul que l'on peut retrouver par exemple dans des centres de données ou dans des salles de calcul.

De nos jours, les serveurs informatiques nécessitent d'interconnecter un grand nombre de cartes électroniques, en les disposants dans des supports tels que des armoires de calcul informatique.

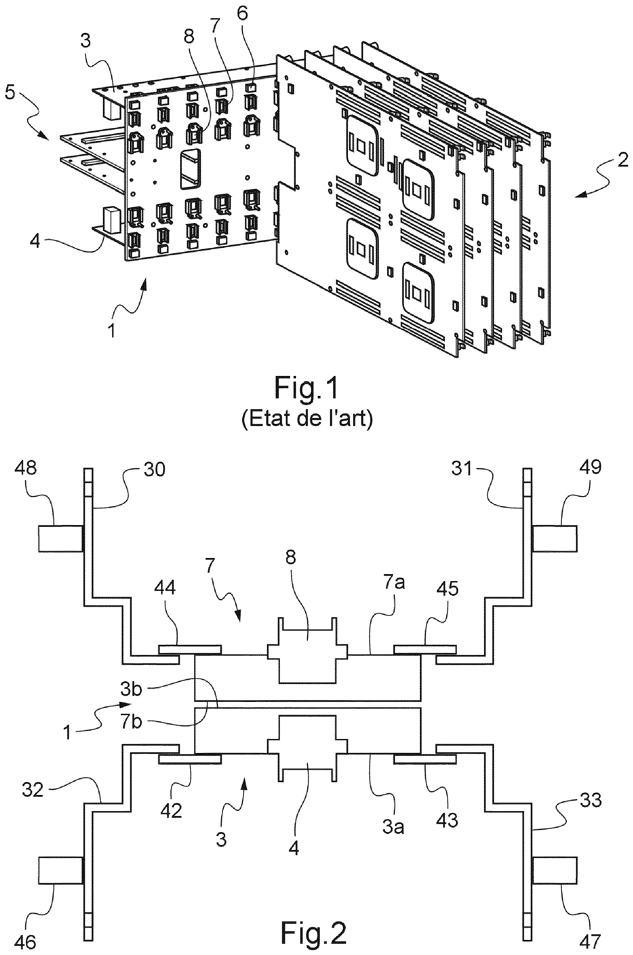

Comme illustré dans les références brevets US 2016/036727, US 2015/296652, US 2015/116923 et EP 3139447, on connaît déjà des armoires dans lesquelles sont intégrés des systèmes permettant d'interconnecter des cartes électroniques. Pour interconnecter ces cartes, on utilise généralement une configuration telle que celle représentée à la figure 1.

Un tel système comprend une carte électronique mère 1 fixée dans le fond du châssis de l'armoire, pourvue d'un certain nombre de connecteurs 6, 7, 8 permettant la connexion de cartes électroniques filles 2 d'un premier côté, orientées dans un premier plan, et de cartes électroniques filles 3, 4, 5 de l'autre côté, orientées dans un deuxième plan perpendiculaire au premier plan.

Un tel système présente cependant plusieurs inconvénients, parmi lesquels les inconvénients qui suivent.

Tout d'abord, ce système ne permet pas d'interconnecter facilement des cartes électroniques distantes dans l'armoire, par exemple des cartes qui seraient connectées à une carte mère disposée en haut de l'armoire et des cartes qui seraient connectées à une carte mère disposée en bas de l'armoire.

Par ailleurs, ce système ne permet pas d'interconnecter facilement un grand nombre de cartes filles, par exemple sur une grande hauteur, la limite étant donnée par la taille maximale que peut prendre une carte électronique mère.

En outre, ce système nécessite l'utilisation d'un autre système à l'interface entre le système d'interconnexion proprement dit et l'armoire, pour pouvoir s'adapter à la géométrie de l'armoire et être inséré dans celle-ci.

Egalement, ce système ne permet pas de connecter des cartes de chaque côté de manière coplanaire.

Un des buts de l'invention est donc de résoudre notamment les problèmes précités. Ainsi, l'invention a notamment pour objectif de proposer un système d'interconnexion de cartes électroniques destiné à être intégré dans une armoire de calcul informatique indépendamment de la géométrie de cette armoire, qui permette d'interconnecter facilement un grand nombre de cartes électroniques tant par l'avant que par l'arrière et situées à une distance importante l'une de l'autre, et qui soit facile à installer.

L'invention a ainsi pour objet, selon un premier aspect, un système d'interconnexion de cartes électroniques destiné à être intégré dans une armoire de calcul informatique comprenant une paroi avant et une paroi arrière caractérisé en ce que la paroi avant comprend un premier demi-boitier présentant une face externe et une face interne.

La face externe de la paroi avant comprend au moins un moyen de connexion avant destiné à permettre la connexion d'une carte électronique avant, le moyen de connexion avant étant relié à un ou plusieurs câbles de connexion avant du côté de la face interne de la paroi avant.

La paroi arrière comprend un deuxième demi-boitier présentant une face externe et une face interne, la face externe de la paroi arrière comprenant au moins un moyen de connexion arrière destiné à permettre la connexion d'une carte électronique arrière, le moyen de connexion arrière étant relié à un ou plusieurs câbles de connexion arrière du côté de la face interne de la paroi arrière.

Chacun des deux demi-boitiers forme un logement délimité par les faces externes et internes à l'intérieur duquel le ou les câbles de connexion sont disposés.

Les parois avant et arrière sont solidarisables de manière temporaire par leurs faces interne respectives par l'intermédiaire de moyens de fixation, en sorte d'assembler les deux demi-boitiers pour former un boîtier.

Suivant certains modes de mise en œuvre, le système comprend en outre une ou plusieurs des caractéristiques suivantes, prise(s) isolément ou suivant toutes les combinaisons techniquement possibles :
- la face externe de la paroi avant comprend au moins deux moyens de connexion avant reliés entre eux par tout ou partie des câbles de connexion avant du côté de la face interne de la paroi avant ;
- au moins une partie des câbles de connexion avant est reliée au moyen de connexion arrière et au moins une partie des câbles de connexion arrière est reliée à au moins un des moyens de connexion avant ;
- les faces internes respectives des parois avant et arrière présentent chacune une ouverture de passage d'au moins une partie des câbles de connexion avant et arrière de la paroi avant vers la paroi arrière et réciproquement ;
- la face externe de la paroi arrière comprend au moins deux moyens de connexion arrière reliés entre eux par tout ou partie des câbles de connexion arrière du côté de la face interne de la paroi arrière ;
- les moyens de connexion avant et/ou les moyen de connexion arrière comprennent un ou plusieurs connecteur destinés à permettre la connexion d'une carte électronique par enfichage, et la face externe de la paroi avant, respectivement la face externe la paroi arrière, sont pourvues de moyens de guidage destinés à guider l'enfichage de la carte électronique dans le ou les connecteurs ;
- les moyens de fixation comprennent un ou plusieurs premiers éléments de fixation disposés sur la face interne de la paroi avant, et un ou plusieurs deuxièmes éléments de fixation disposés sur la face interne de la paroi arrière, les premiers éléments de fixation étant aptes à coopérer avec les deuxièmes éléments de fixation pour assurer la solidarisation temporaire de la paroi avant avec la paroi arrière ;
- la paroi avant et la paroi arrière présentent chacune une plus grande dimension, la plus grande dimension de l'une des parois avant et arrière, ou plus grande paroi, étant supérieure à celle de l'autre des parois avant et arrière, ou plus petite paroi ;
- le système comprend une première et une deuxième brides fixées à la plus grande paroi à l'opposé l'une de l'autre selon la plus grande dimension de cette plus grande paroi, les première et deuxième brides étant configurées pour dépasser de la plus grande paroi en sorte de présenter chacune une portion de bridage s'étendant respectivement au-dessus de deux zones bridage de la plus petite paroi opposées l'une de l'autre selon la plus grande dimension de cette plus petite paroi ;
- la portion de bridage d'au moins une des première et deuxième brides est pourvue d'un ou plusieurs plots, et la zone de bridage correspondante de la plus petite paroi est pourvue d'une ou plusieurs découpes, lesdits plots étant aptes à pénétrer dans lesdites découpes ;
- la portion de bridage d'au moins une des première et deuxième brides est pourvue d'une ou plusieurs découpes, et la zone de bridage correspondante de la plus petite paroi est pourvue d'un ou plusieurs plots, lesdits plots étant aptes à pénétrer dans lesdites découpes.

L'invention a également pour objet, selon un deuxième aspect, une armoire de calcul informatique destinée à intégrer plusieurs cartes électroniques interconnectées, et comprenant au moins un système d'interconnexion tel que présenté ci-dessus.

De préférence, l'armoire présente deux parois latérale espacées d'une distance donnée, le système d'interconnexion étant monté à l'intérieur de l'armoire en sorte de s'étendre entre les deux parois latérales selon l'une déterminée des dimensions du système d'interconnexion, ladite dimension déterminée étant inférieure à ladite distance donnée, le système d'interconnexion étant fixé aux parois latérales au moyen d'éléments d'ajustement latéraux.

Ainsi, le système d'interconnexion de l'invention, permet de connecter entre elles à l'aide de câbles des cartes électroniques situées à l'avant et à l'arrière d'une armoire, de manière coplanaire.

Il permet également d'interconnecter des cartes électroniques espacées l'une de l'autre, par exemple placées tout en haut et tout en bas de l'armoires de calcul, soit par l'interconnexion de plusieurs systèmes selon l'invention superposés dans l'armoire, soit par l'utilisation d'un seul système selon l'invention de taille suffisante.

Les moyens de guidage de l'enfichage des cartes électroniques permettent par ailleurs une connexion de ces cartes électroniques à l'aveugle

En outre, le système selon l'invention permet une connexion optimale des cartes électroniques avec les câbles de connexion, malgré des éventuels défauts géométriques de l'armoire de calcul, et indépendamment de la taille de l'armoires.

Par ailleurs, le système selon l'invention est facile à monter dans, et à démonter de, l'armoire par un opérateur, et se transporte facilement en dehors de l'armoire, sans risque d'endommagement.

Les caractéristiques et avantages de l'invention apparaitront à la lecture de la description qui va suivre, donnée uniquement à titre d'exemple, et non limitative, en référence aux figures annexées suivantes :
- figure 2 : représentation schématique en vue de dessus d'un premier exemple système selon l'invention;
- figure 3 : représentation schématique en vue de dessus d'un deuxième exemple du système selon l'invention;
- figure 4 : représentation schématique d'un exemple de montage des câbles de connexion dans un système selon l'invention ;
- figure 5 : représentation schématique en vue de côté d'un exemple de système selon l'invention ;
- figure 6 : représentation schématique d'un exemple de bride utilisée dans le système représenté à la figure 5 ;
- figure 7 : représentation schématique de la partie avant et de la partie arrière d'un exemple de système selon l'invention, avant assemblage ;
- figure 8 : représentation schématique d'un exemple de système selon l'invention vue par l'une de ses faces avant ou arrière, intégré dans une armoire.

La figure 1 correspond à un système de l'état de la technique et est commentée plus haut.

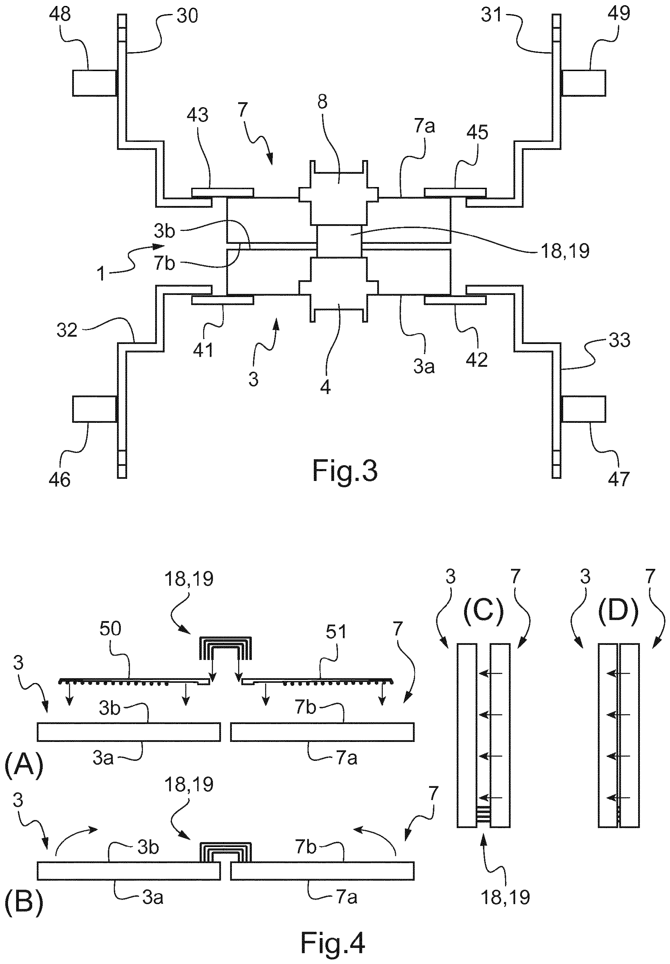

Sur les figures 2 et 3 sont représentés schématiquement et respectivement deux exemples de système 1 d'interconnexion de cartes électroniques selon l'invention, en vue de dessus.

Le système 1 comprend une paroi avant 3 et une paroi arrière 7. La paroi avant 3 présente une face externe 3a, et une face interne 3b opposée à la face externe 3a. DE façon analogue, la paroi arrière 7 comprend une face externe 7a, et une face interne 7b opposée à la face externe 7a.

Dans ces deux exemples, la face externe 3a de la paroi avant 3 comprend au moins un moyen de connexion avant 4, et la face externe 7a de la paroi arrière 7 comprend au moins un moyen de connexion arrière 8.

Ces moyens de connexion avant 4 et arrière 8 sont chacun destinés à permettre la connexion d'une carte électronique.

Chaque moyen de connexion avant 4 et arrière 8 est relié à un ou plusieurs câbles de connexion, ou faisceau de câbles de connexion, du côté de la face interne de la paroi correspondante.

Dans l'exemple de la figure 2, ces câbles de connexion ne sont pas représentés. Ainsi, des câbles de connexion avant, du côté de la face interne 3b de la paroi avant 3, relient les moyens de connexion avant 4 à d'autres moyens de connexion avant du système 1, ou d'un autre système d'interconnexion selon l'invention. Par ailleurs, des câbles de connexion arrière, du côté de la face interne 7b de la paroi arrière 7, relient les moyens de connexion arrière 8 à d'autres moyens de connexion arrière du système 1, ou d'un autre système d'interconnexion selon l'invention.

Dans l'exemple de la figure 3, des câbles de connexion 18, 19, du côté des faces internes respectives 3b, 7b des parois avant et arrière 3, 7, relient les moyens de connexion avant 4 et les moyens de connexion arrière 8.

Les parois avant 3 et arrière 7 sont solidarisables de manière temporaire par leurs faces interne respectives 3b, 7b par l'intermédiaire de moyens de fixation qui seront décrits plus loin dans un mode de réalisation particulier.

De la sorte, le système 1 forme un boîtier 1 d'interconnexion à l'intérieur duquel le ou les câbles de connexion avant et/ou arrière sont disposés.

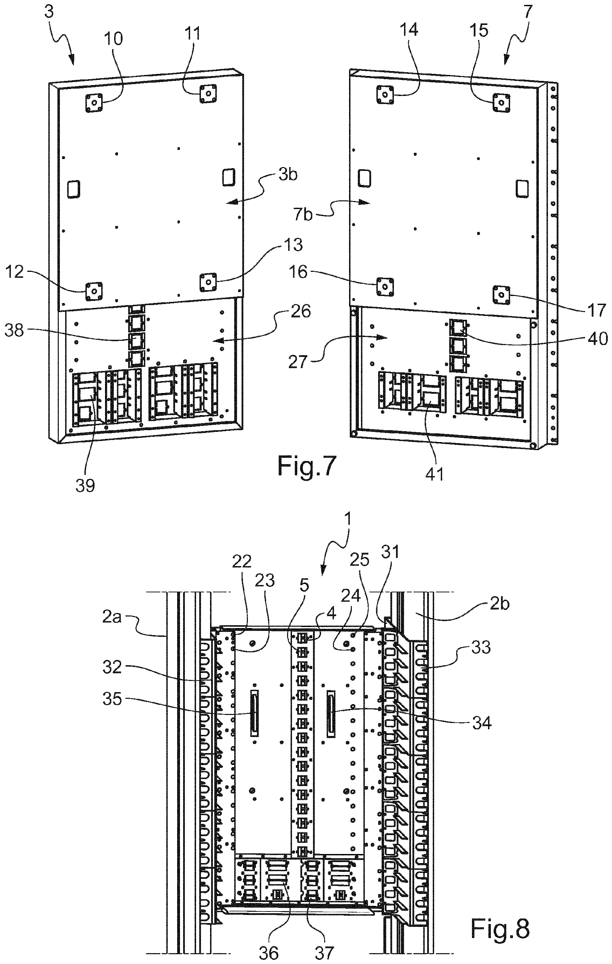

Le système 1 est monté dans une armoire, non représentée sur les figures 2 et 3, mais qui sera décrite plus loin en relation avec la figure 8.

Ce montage dans une armoire est obtenu par l'intermédiaire d'éléments d'ajustement latéraux 30 à 33. On prévoit deux éléments d'ajustement latéraux pour chacune des parois avant 3 et arrière 4. Ainsi, les éléments d'ajustement latéraux 30 et 31 sont prévus de chaque côté de la paroi arrière 7, et les éléments d'ajustement latéraux 32 et 33 sont prévus de chaque côté de la paroi avant 3.

Ces éléments d'ajustement latéraux 30 à 33 sont fixés à l'intérieur des parois latérales de l'armoire représentées schématiquement par les blocs 46 à 49 sur les figures 2 et 3, ou indirectement via des pièces d'interface. Ainsi, les éléments d'ajustement latéraux 30 et 32, d'un côté respectivement de la paroi arrière 7 et de la paroi avant 3, sont fixés à l'une des parois latérales de l'armoire via les pièces d'interface respectives 48 et 46. De même, les éléments d'ajustement latéraux 31 et 33, de l'autre côté respectivement de la paroi arrière 7 et de la paroi avant 3, sont fixés à l'autre des parois latérales de l'armoire via les pièces d'interface respectives 49 et 47.

Dans les deux cas, le système 1 est fixé aux éléments d'ajustement latéraux 30 à 33 par des pièces de fixation latérales 41 à 43. On prévoit une pièce de fixation latérale 41, 42 de chaque côté de la paroi avant 3, permettant de fixer la paroi avant 3 respectivement aux éléments d'ajustement latéraux 32, 33. De même, on prévoit une pièce de fixation latérale 43, 45 de chaque côté de la paroi arrière 7, permettant de fixer la paroi arrière 7 respectivement aux éléments d'ajustement latéraux 30, 31.

La figure 4 représente schématiquement les principales étapes d'un exemple de montage des câbles de connexion dans un système selon l'invention tel que le système de la figure 3.

En position (A), les parois avant 3 et arrière 7 sont séparées, et les câbles avant et arrière 18, 19 sont amenés en position au-dessus des faces internes 3b, 7b respectives de ces parois avant et arrière 3, 7, en vue de leur connexion aux moyens de connexion (non représentés) des parois 3, 7 du côté de leurs faxes internes respectives 3b, 7b. Au besoin, des éléments de câblage complémentaires 50 et 51 sont utilisés pour la connexion du faisceau principal 18, 19.

Une fois en position de connexion et avant la fermeture du système 1, tel que représenté en position (B), les câbles 18, 19, 50, 51 ne sont plus visibles que par l'intermédiaire de la portion qui ressort de la paroi avant 3 pour aller vers la paroi arrière 7 et réciproquement.

Les parois avant 3 et arrière 7 sont alors ramenées l'une vers l'autre en position (C), leurs faces internes respectives 3b et 7b étant en vis-à-vis. Puis, la paroi avant 3 et la paroi arrière 7 sont solidarisées l'une à l'autre, en sorte de se retrouver verrouillées temporairement pour former un boîtier 1 dans lequel sont disposés tous les câbles, tel que représenté en position (D).

La mise en position des câbles dans le système 1 ou boîtier 1, est délicate. Une sur-longueur de câbles est prévue pour la phase d'assemblage du système 1 décrite ci-dessus, et une zone de résorption de cette sur-longueur est prévue dans le système 1 formant boîtier 1.

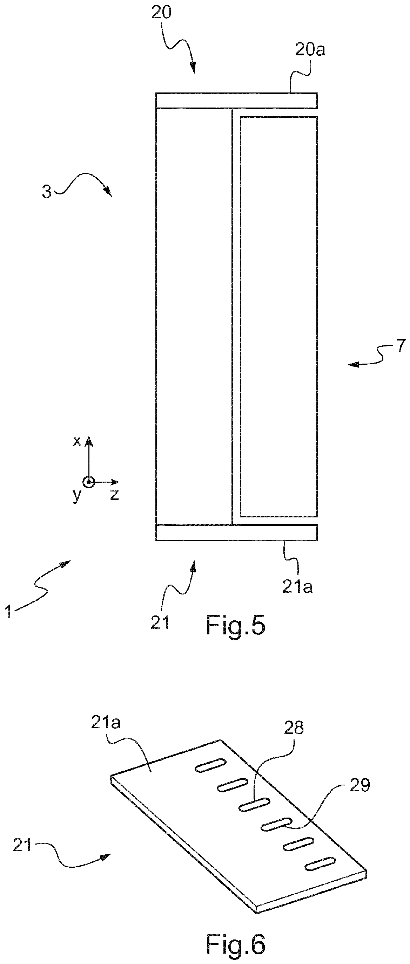

La figure 5 représente schématiquement en vue de côté un autre exemple de système selon l'invention.

La paroi avant 3 et la paroi arrière 7 du système 1 présentent chacune une plus grande dimension. Dans l'exemple de la figure 3, la plus grande dimension de la paroi avant 3 est supérieure à celle de la paroi arrière 7. Alternativement, la plus grande dimension de la paroi arrière 7 pourrait être supérieure à celle de la paroi avant 3.

On appelle plus grande, respectivement plus petite, paroi, celle des parois avant 3 et arrière 7 dont la plus grande dimension est supérieure, respectivement inférieure, à la plus grande dimension de l'autre. Dans l'exemple de la figure 3, la paroi avant 3 est donc la plus grande paroi, et la paroi arrière 7 est donc la plus petite paroi.

Dans cet exemple, on prévoit une première et une deuxième brides 20, 21, typiquement une bride haute 20 et une bride basse 21, cette dernière étant représentée schématiquement dans un exemple sur la figure 6 de manière isolée.

Chacune des brides 20, 21 est fixée, par exemple par des vis, à la plus grande paroi 3 à l'opposé l'une de l'autre selon la plus grande dimension de cette plus grande paroi 3. Par ailleurs, chacune de ces brides 20, 21 est configurées pour, une fois fixée à la plus grande paroi 3, dépasser de cette plus grande paroi 3 en sorte de s'étendre chacune au-dessus d'un côté de la plus petite paroi 7.

Ainsi, la bride haute 20 présente une portion de bridage 20a qui s'étend au-dessus d'un côté de la plus petite paroi 7, appelé zone de bridage haut de la plus petite paroi 7. Par ailleurs, la bride basse 21 présente une portion de bridage 21a qui s'étend au-dessus d'un autre côté de la plus petite paroi 7, appelé zone de bridage bas de la plus petite paroi 7. La zone de bridage haut de la plus petite paroi 7 et la zone de bridage bas de cette plus petite paroi 7 sont opposées l'une de l'autre selon la plus grande dimension de la plus petite paroi 7.

Pour permettre une certaine quantité et un certain type de mouvement relatif de la plus petite paroi 7 par rapport à la plus grande paroi 3, la portion de bridage 20a, 21a de l'une et/ou l'autre des deux brides 20, 21 est pourvue d'un ou plusieurs plots qui coopèrent avec une ou plusieurs découpes correspondantes dans la zone de bridage correspondante de la plus petite paroi 7. Les plots de la bride 20, 21 sont ainsi aptes à pénétrer dans les découpes de la zone de bridage haut et/ou bas.

Alternativement, les découpes 28, 29 sont formées dans portion de bridage 20a, 21a de la bride concernée, tel que représenté en figure 6, et les plots sont alors formés dans la zone de bridage haut et/ou bas de la plus petite paroi 7. Les plots de la zone de bridage haut et/ou bas de la paroi 7 sont ainsi aptes à pénétrer dans les découpes de la portion de bridage 20a, 21a.

En fonction de la forme et de la taille des découpes et des plots, ces derniers peuvent se déplacer dans les découpes, ce qui créé une possibilité de mouvement de la plus petite paroi 7 par rapport à la plus grande paroi 3.

De préférence, au moins deux découpes coopèrent avec au moins deux plots, en partie haute et en partie basse, pour limiter le phénomène de pivot de la plus petite paroi 7 qui peut se produire autour de l'axe correspondant à la plus grande dimension de la plus petite paroi 7.

Ainsi, le système 1, ou boîtier 1, est rendu flexible en le séparant en deux demi-boîtiers 3, 7 distincts, ou paroi avant et arrière 3, 7 distinctes, avec un mouvement relatif selon trois axes correspondant aux trois dimensions du système 1, permis par les deux brides 20, 21, et par la différence entre la plus grande dimension de la paroi avant 3 et la plus grande dimension de la paroi arrière 7.

Ces degrés de liberté permettent de compenser un éventuel décalage avec les dimensions de l'armoire dans laquelle le système 1 est censé être intégré. Ces degrés de liberté sont toutefois limités pour ne pas endommager les câbles de connexion qui passe de la paroi avant à la paroi arrière et réciproquement.

La figure 7 représente schématiquement la partie avant 3 et de la partie arrière 7 d'un exemple de système 1 selon l'invention, avant assemblage, du côté de leurs faces internes respectives 3b, 7b.

Sur la face interne 3b de la paroi avant 3, sont disposés des premiers éléments de fixation 10 à 13, et sur la face interne 7b de la paroi arrière 7, sont disposés des deuxièmes éléments de fixation 14 à 17. Ces premiers éléments de fixation 10 à 13 et deuxièmes éléments de fixation 14 à 17 forment les moyens de fixation 10 à 17 permettant de solidariser la paroi avant 3 avec la paroi arrière 7 par leurs faces internes respectives 3b, 7b. Ainsi, les premiers éléments de fixation 10 à 13 sont aptes à coopérer avec les deuxièmes éléments de fixation 14 à 17 pour assurer cette solidarisation de la paroi avant 3 avec la paroi arrière 7.

Dans l'exemple représenté à la figure 7, quatre premiers éléments de fixation 10 à 13 sont donc disposés sur la face interne 3b de la paroi avant 3, en vue de coopérer un à un avec l'un des quatre deuxièmes éléments de fixation 14 à 17 disposés sur la face interne 7b de la paroi arrière 7.

Ces éléments de fixation peuvent être des éléments de verrouillage permettant de brider tout mouvement relatif entre la paroi avant 3 et la paroi arrière 7 durant les phases de transport et d'installation dans l'armoire.

A titre d'exemple, les éléments de fixation 14 à 17 sur la face interne 7b de la paroi arrière 7, peuvent être quatre vis imperdables solidaires sur cette face interne 7b, et les éléments de fixation 10 à 13 sur la face interne 3b de la paroi avant 3, peuvent être quatre écrous sertis solidaires de cette face interne 3b.

Le nombre d'élément de fixation peut varier en fonction de la taille du système 1.

Chacune des parois avant 3 et arrière 7 forment un logement délimité notamment par les faces externes 3a, 7a et internes 3b, 7b.

Tout ou partie des câbles de connexion, non représentés sur la figure 7, peut donc être disposée à l'intérieur de ces logements formant des demi-boîtiers du boitier 1.

Dans l'exemple, les faces internes 3b, 7b sont formées par des plaques 3b, 7b qui assurent une fonction de butée mécanique et garantissent un espace minimal entre les parties avant et arrière, pour ne pas pincer les câbles qui de la partie avant 3 à la partie arrière 7 et réciproquement.

Une ouverture 26, 27 est prévue dans chaque face interne 3b, 7b, en vue notamment de faciliter le passage de tout ou partie des câbles de connexion de l'une vers l'autre des deux parois avant et arrière 3, 7, et de faciliter le passage de ces câbles de connexion vers l'extérieur du système 1 ou boîtier 1.

Au travers de ces ouvertures 26, 27, on peut respectivement apercevoir partiellement l'intérieur de la paroi avant 3 ou demi-boitier 3, et partiellement l'intérieur de la paroi arrière 7 ou demi-boîtier 7.

Les ouvertures 26, 27 ne sont pas nécessairement limitées à la partie basse du système 1, tel que représenté sur la figure 7. Elles pourraient éventuellement s'étendre sur une plus grande hauteur, voire sur toute la hauteur.

Des orifices 38, 39 sont ménagés dans la face externe 3a de la paroi avant 3, pour y loger des connecteurs, non représentés, formant les moyens de connexion avant. Par ailleurs, des orifices 40, 41 sont ménagés dans la face externe 7a de la paroi arrière 7, pour y loger des connecteurs, non représentés, formant les moyens de connexion arrière.

Un exemple de système 1 selon l'invention est représenté vue par la face externe de l'une de ses parois, intégré dans une armoire 2a, 2b. Il peut tout aussi bien s'agir de la paroi avant ou de la paroi arrière.

Pour simplifier, la représentation de l'armoire 2a, 2b est limitée à une portion de l'une 2a de ses parois latérales 2a, 2b et une portion de l'autre 2b de ses deux parois latérales 2a, 2b.

Comme déjà mentionné plus haut, des éléments d'ajustement latéraux, dont les éléments 32, 33, sont utilisés pour permettre l'intégration du système 1 dans l'armoire 2a, 2b indépendamment des dimensions de l'armoire, notamment de l'écartement ou la distance entre les deux parois latérales 2a, 2b. Ainsi, lorsque la dimension latérale du système 1, c'est-à-dire la dimension du système 1 qui s'étend entre les parois latérales 2a, 2b, est inférieure à la distance déterminée entre les deux parois latérales 2a, 2b, les éléments d'ajustements latéraux, dont les éléments 32, 33, viennent compenser l'écart.

Tel que représenté sur la figure 7, la face externe de la paroi (avant et/ou arrière) comprend plusieurs moyens de connexion avant 4, 5, 36, 37 qui peuvent ou non être reliés entre eux par tout ou partie des câbles de connexion (avant ou arrière) du côté de la face interne de la paroi (avant ou arrière).

Chaque moyen de connexion avant ou arrière peut comprend un ou plusieurs connecteurs qui permettent la connexion d'une carte électronique par enfichage.

Ainsi, par exemple, les moyens de connexion 4, 5 comprennent chacun un unique connecteur 4, 5, alors d'autres moyens de connexion vers le bas du système 1 comprennent plusieurs connecteurs dont le connecteur 36 ou le connecteur 37.

Pour faciliter l'enfichage des cartes électroniques dans les connecteurs 4, 5, 36, 37, des moyens de guidage sont prévus, tels que les moyens de guidage 22 à 25 pour le connecteur 4, qui peuvent prendre la forme de plots 22 à 25 venant guider le bord de connexion de la carte électronique vers le connecteur 4.

Un ou plusieurs moyens de préhension 34, 35, tel que des poignées 34, 35, peuvent être ménagés dans la face externe de la paroi (avant ou arrière), pour faciliter la manutention et le transport du système 1.

La présente description est donnée à titre d'exemple et n'est pas limitative de l'invention.

## Revendications

1. Système d'interconnexion (1) de cartes électroniques destiné à être intégré dans une armoire (2a, 2b) de calcul informatique comprenant une paroi avant (3) et une paroi arrière (7),
**caractérisé en ce que** la paroi avant (3) comprend un premier demi-boitier présentant une face externe (3a) et une face interne (3b), la face externe (3a) de la paroi avant (3) comprenant au moins un moyen de connexion avant (4, 5) destiné à permettre la connexion d'une carte électronique avant, le moyen de connexion avant (4, 5) étant relié à un ou plusieurs câbles de connexion avant (18) du côté de la face interne (3b) de la paroi avant (3),
la paroi arrière (7) comprend un deuxième demi-boitier présentant une face externe (7a) et une face interne (7b), la face externe (7a) de la paroi arrière (7) comprenant au moins un moyen de connexion arrière (8) destiné à permettre la connexion d'une carte électronique arrière, le moyen de connexion arrière (8) étant relié à un ou plusieurs câbles de connexion arrière (19) du côté de la face interne (7b) de la paroi arrière (7),
chacun des deux demi-boitiers formant un logement délimité par les faces externes (3a, 7a) et internes (3b, 7b) à l'intérieur duquel le ou les câbles de connexion sont disposés,
les parois avant (3) et arrière (7) étant solidarisables de manière temporaire par leurs faces internes respectives (3b, 7b) par l'intermédiaire de moyens de fixation (10 à 17), en sorte d'assembler lesdits deux demi-boitiers pour former un boîtier (1).

2. Système (1) selon la revendication 1, **caractérisé en ce que** la face externe (3a) de la paroi avant (3) comprend au moins deux moyens de connexion avant (4, 5) reliés entre eux par tout ou partie des câbles de connexion avant (18) du côté de la face interne (3b) de la paroi avant (3).

3. Système (1) selon la revendication 1, **caractérisé en ce qu'**au moins une partie des câbles de connexion avant (18) est reliée au moyen de connexion arrière (8) et au moins une partie des câbles de connexion arrière (19) est reliée à au moins un des moyens de connexion avant (4, 5).

4. Système (1) selon la revendication 3, **caractérisé en ce que** les faces internes respectives (3b, 7b) des parois avant et arrière (3, 7) présentent chacune une ouverture (26, 27) de passage d'au moins une partie des câbles de connexion avant et arrière (18, 19) de la paroi avant (3) vers la paroi arrière (7) et réciproquement.

5. Système (1) selon l'une quelconque des revendications 1 à 4, **caractérisé en ce que** la face externe (7a) de la paroi arrière (7) comprend au moins deux moyens de connexion arrière (8) reliés entre eux par tout ou partie des câbles de connexion arrière (19) du côté de la face interne (7b) de la paroi arrière (7).

6. Système (1) selon l'une quelconque des revendications 1 à 5, **caractérisé en ce que** les moyens de connexion avant (4, 5) comprennent un ou plusieurs connecteur (4, 5) destinés à permettre la connexion d'une carte électronique par enfichage, et **en ce que** la face externe (3a) de la paroi avant (3) est pourvue de moyens de guidage (22 à 25) destinés à guider l'enfichage de la carte électronique dans le ou les connecteurs (4, 5).

7. Système (1) selon l'une quelconque des revendications 1 à 5, **caractérisé en ce que** les moyen de connexion arrière (8) comprennent un ou plusieurs connecteur (4, 5) destinés à permettre la connexion d'une carte électronique par enfichage, et **en ce que** la face externe (7a) la paroi arrière (7) est pourvue de moyens de guidage (22 à 25) destinés à guider l'enfichage de la carte électronique dans le ou les connecteurs (4, 5).

8. Système (1) selon l'une quelconque des revendications 1 à 7, **caractérisé en ce que** les moyens de fixation (10 à 17) comprennent un ou plusieurs premiers éléments de fixation (10 à 13) disposés sur la face interne (3b) de la paroi avant (3), et un ou plusieurs deuxièmes éléments de fixation (14 à 17) disposés sur la face interne (7b) de la paroi arrière (7), les premiers éléments de fixation (10 à 13) étant aptes à coopérer avec les deuxièmes éléments de fixation (14 à 17) pour assurer la solidarisation temporaire de la paroi avant (3) avec la paroi arrière (7).

9. Système (1) selon l'une quelconque des revendications 1 à 8, **caractérisé en ce que** la paroi avant (3) et la paroi arrière (7) présentent chacune une plus grande dimension, la plus grande dimension de l'une des parois avant (3) et arrière (7), ou plus grande paroi (3, 7), étant supérieure à la plus grande dimension de l'autre des parois avant (3) et arrière (7), ou plus petite paroi (7, 3).

10. Système selon la revendication 9, **caractérisé en ce qu'**il comprend une première et une deuxième brides (20, 21) fixées à la plus grande paroi (3, 7) à l'opposé l'une de l'autre selon la plus grande dimension de cette plus grande paroi(3, 7), les première et deuxième brides (20, 21) étant configurées pour dépasser de la plus grande paroi (3, 7) en sorte de présenter chacune une portion de bridage (20a, 21a) s'étendant respectivement au-dessus de deux zones bridage de la plus petite paroi (7, 3) opposées l'une de l'autre selon la plus grande dimension de cette plus petite paroi (7, 3).

11. Système (1) selon la revendication 10, **caractérisé en ce que** la portion de bridage (20a, 21a) d'au moins une des première et deuxième brides (20, 21) est pourvue d'un ou plusieurs plots, et **en ce que** la zone de bridage correspondante de la plus petite paroi (7, 3) est pourvue d'une ou plusieurs découpes, lesdits plots étant aptes à pénétrer dans lesdites découpes.

12. Système (1) selon la revendication 10, **caractérisé en ce que** la portion de bridage (20a, 21a) d'au moins une des première et deuxième brides (20, 21) est pourvue d'une ou plusieurs découpes (28, 29), et **en ce que** la zone de bridage correspondante de la plus petite paroi (7, 3) est pourvue d'un ou plusieurs plots, lesdits plots étant aptes à pénétrer dans lesdites découpes (28, 29).

13. Armoire (2a, 2b) de calcul informatique destinée à intégrer plusieurs cartes électroniques interconnectées, comprenant au moins un système d'interconnexion (1) selon l'une quelconque des revendications précédentes.

14. Armoire (2a, 2b) selon la revendication précédente, **caractérisée en ce qu'**elle présente deux parois latérales (2a, 2b) espacées d'une distance donnée, le système d'interconnexion (1) étant monté à l'intérieur de l'armoire (2) en sorte de s'étendre entre les deux parois latérales (2a, 2b) selon l'une déterminée des dimensions du système d'interconnexion (1), ladite dimension déterminée étant inférieure à ladite distance donnée, le système d'interconnexion (1) étant fixé aux parois latérales (2a, 2b) au moyen d'éléments d'ajustement latéraux (30 à 33).

## Patentansprüche

1. Elektronisches Kartenverbindungssystem (1), das dafür bestimmt ist, in einen Computerberechnungskasten (2a, 2b) integriert zu werden, der eine Vorderwand (3) und eine Hinterwand (7) umfasst,
**dadurch gekennzeichnet, dass** die Vorderwand (3) eine erste Gehäusehälfte umfasst, die eine Außenfläche (3a) und eine Innenfläche (3b) aufweist, wobei die Außenfläche (3a) der Vorderwand (3) wenigstens ein vorderes Anschlussmittel (4, 5) umfasst, das dafür bestimmt ist, den Anschluss einer vorderen elektronischen Karte zu ermöglichen, wobei das vordere Anschlussmittel (4, 5) mit einem oder mehreren vorderen Anschlusskabeln (18) auf der Seite der Innenfläche (3b) der Vorderwand (3) verbunden ist,
die Hinterwand (7) eine zweite Gehäusehälfte umfasst, die eine Außenfläche (7a) und eine Innenfläche (7b) aufweist, wobei die Außenfläche (7a) der Hinterwand (7) wenigstens ein hinteres Anschlussmittel (8) umfasst, das dafür bestimmt ist, den Anschluss einer hinteren elektronischen Karte zu ermöglichen, wobei das hintere Anschlussmittel (8) mit einem oder mehreren hinteren Anschlusskabeln (19) auf der Seite der Innenfläche (7b) der Hinterwand (7) verbunden sind,
jede der zwei Gehäusehälften ein durch die Außen- (3a, 7a) und die Innenflächen (3b, 7b) begrenztes Gehäuse ausbildet, in dessen Innerem das oder die Anschlusskabel angeordnet sind,
wobei die Vorder- (3) und die Hinterwand (7) durch ihre jeweiligen Innenflächen (3b, 7b) durch Anbringungsmittel (10 bis 17) vorübergehend befestigbar sind, um die zwei Gehäusehälften zum Ausbilden eines Gehäuses (1) zusammenzufügen.

2. System (1) nach Anspruch 1, **dadurch gekennzeichnet, dass** die Außenfläche (3a) der Vorderwand (3) wenigstens zwei vordere Anschlussmittel (4, 5) umfasst, die durch alle oder einen Teil der vorderen Anschlusskabel (18) auf der Seite der Innenfläche (3b) der Vorderwand (3) miteinander verbunden sind.

3. System (1) nach Anspruch 1, **dadurch gekennzeichnet, dass** wenigstens ein Teil der vorderen Anschlusskabel (18) mit einem hinteren Anschlussmittel (8) verbunden ist und wenigstens ein Teil der hinteren Anschlusskabel (19) mit wenigstens einem der vorderen Anschlussmittel (4, 5) verbunden ist.

4. System (1) nach Anspruch 3, **dadurch gekennzeichnet, dass** die jeweiligen Innenseiten (3b, 7b) der Vorder- und der Hinterwand (3, 7) jeweils eine Durchgangsöffnung (26, 27) für wenigstens einen Teil der vorderen und der hinteren Anschlusskabel (18, 19) von der Vorderwand (3) zu der Hinterwand (7) und umgekehrt aufweisen.

5. System (1) nach einem der Ansprüche 1 bis 4, **dadurch gekennzeichnet, dass** die Außenfläche (7a) der Hinterwand (7) wenigstens zwei hintere Anschlussmittel (8) umfasst, die durch alle oder einen Teil der hinteren Anschlusskabel (19) auf der Seite der Innenfläche (7b) der Hinterwand (7) miteinander verbunden sind.

6. System (1) nach einem der Ansprüche 1 bis 5, **dadurch gekennzeichnet, dass** die vorderen Anschlussmittel (4, 5) einen oder mehrere Verbinder (4, 5) umfassen, die dafür bestimmt sind, den Anschluss einer elektronischen Karte durch Stecken zu ermöglichen, und dadurch, dass die Außenfläche (3a) der Vorderwand (3) mit Führungsmitteln (22 bis 25) versehen ist, die dafür bestimmt sind, das Stecken der elektronischen Karte in den oder die Verbinder (4, 5) zu führen.

7. System (1) nach einem der Ansprüche 1 bis 5, **dadurch gekennzeichnet, dass** die hinteren Anschlussmittel (8) einen oder mehrere Verbinder (4, 5) umfassen, die dafür bestimmt sind, den Anschluss einer elektronischen Karte durch Stecken zu ermöglichen, und dadurch, dass die Außenfläche (7a) der Hinterwand (7) mit Führungsmitteln (22 bis 25) versehen ist, die dafür bestimmt sind, das Stecken der elektronischen Karte in den oder die Verbinder (4, 5) zu führen.

8. System (1) nach einem der Ansprüche 1 bis 7, **dadurch gekennzeichnet, dass** die Anbringungsmittel (10 bis 17) ein oder mehrere erste Anbringungsmittel (10 bis 13), die an der Innenseite (3b) der Vorderwand (3) angeordnet sind, und ein oder mehrere zweite Anbringungsmittel (14 bis 17) umfassen, die an der Innenseite (7b) der Hinterwand (7) angeordnet sind, wobei die ersten Anbringungsmittel (10 bis 13) geeignet sind, um mit den zweiten Anbringungsmitteln (14 bis 17) zum Sicherstellen der vorübergehenden Befestigung der Vorderwand (3) mit der Hinterwand (7) zusammenzuwirken.

9. System (1) nach einem der Ansprüche 1 bis 8, **dadurch gekennzeichnet, dass** die Vorderwand (3) und die Hinterwand (7) jeweils eine größere Abmessung aufweisen, wobei die größte Abmessung der Vorder- (3) oder der Hinterwand (7), oder der größeren Wand (3, 7), größer als die größte Abmessung der anderen der Vorder- (3) oder Hinterwand (7), oder der kleineren Wand (7, 3), ist.

10. System nach Anspruch 9, **dadurch gekennzeichnet, dass** es einen ersten und einen zweiten Flansch (20, 21) umfasst, die angebracht an der größten Wand (3, 7) einander gegenüberliegen, gemäß der größten Abmessung dieser größeren Wand (3, 7), wobei der erste und der zweite Flansch (20, 21) konfiguriert sind, von der größten Wand (3, 7) hervorzustehen, um jeweils einen Anflanschabschnitt (20a, 21a) aufzuweisen, der sich jeweils über zwei Anflanschbereiche der kleinsten Wand (7, 3) einander gegenüberliegend gemäß der größten Abmessung dieser kleineren Wand (7, 3) erstreckt.

11. System (1) nach Anspruch 10, **dadurch gekennzeichnet, dass** der Anflanschabschnitt (20a, 21a) von dem ersten und/oder dem zweiten Flansch (20, 21) mit einem oder mehreren Kontakten versehen ist, und dadurch, dass der entsprechende Anflanschbereich der kleinsten Wand (7, 3) mit einer oder mehreren Ausschnitten versehen ist, wobei die Kontakte geeignet sind, um in die Ausschnitte einzudringen.

12. System (1) nach Anspruch 10, **dadurch gekennzeichnet, dass** der Anflanschabschnitt (20a, 21a) von dem ersten und/oder dem zweiten Flansch (20, 21) mit einem oder mehreren Ausschnitten (28, 29) versehen ist, und dadurch, dass der entsprechende Anflanschbereich der kleinsten Wand (7, 3) mit einem oder mehreren Kontakten versehen ist, wobei die Kontakte geeignet sind, um in die Ausschnitte (28, 29) einzudringen.

13. Computerberechnungskasten (2a, 2b), der dafür bestimmt ist, mehrere miteinander vernetzte elektronische Karten zu integrieren, der wenigstens ein Vernetzungssystem (1) nach einem der vorhergehenden Ansprüche umfasst.

14. Kasten (2a, 2b) nach dem vorhergehenden Anspruch, **dadurch gekennzeichnet, dass** er zwei Seitenwände (2a, 2b) aufweist, die in einem gegebenen Abstand beabstandet sind, wobei das Vernetzungssystem (1) innerhalb des Kastens (2) montiert ist, um sich zwischen den zwei Seitenwänden (2a, 2b) gemäß einer bestimmten der Abmessungen des Vernetzungssystems (1) zu erstrecken, wobei die bestimmte Abmessung kleiner als der gegebene Abstand ist, wobei das Vernetzungssystem (1) an den Seitenwänden (2a, 2b) mittels seitlicher Verstellelemente (30 bis 33) angebracht ist.

## Claims

1. System (1) for interconnecting electronic boards which is intended to be integrated into a computer cabinet (2a, 2b) and comprises a front wall (3) and a rear wall (7),
**characterized in that** the front wall (3) comprises a first half-casing having an outer face (3a) and an inner face (3b), the outer face (3a) of the front wall (3) comprising at least one front connection means (4, 5) intended to allow the connection of a front electronic board, the front connection means (4, 5) being connected to one or more front connection cables (18) on the side of the inner face (3b) of the front wall (3),
the rear wall (7) comprises a second half-casing having an outer face (7a) and an inner face (7b), the outer face (7a) of the rear wall (7) comprising at least one rear connection means (8) intended to allow the connection of a rear electronic board, the rear connection means (8) being connected to one or more rear connection cables (19) on the side of the inner face (7b) of the rear wall (7),
each of the two half-casings forming a housing delimited by the outer faces (3a, 7a) and inner faces (3b, 7b), inside which housing the connection cable(s) are arranged,
the front wall (3) and rear wall (7) being secured temporarily by their respective inner faces (3b, 7b) by means of fixing means (10 to 17) such that said two half-casings are assembled to form a casing (1).

2. System (1) according to claim 1, **characterized in that** the outer face (3a) of the front wall (3) comprises at least two front connection means (4, 5) interconnected by all or some of the front connection cables (18) on the side of the inner face (3b) of the front wall (3).

3. System (1) according to claim 1, **characterized in that** at least some of the front connection cables (18) are connected to the rear connection means (8) and at least some of the rear connection cables (19) are connected to at least one of the front connection means (4, 5).

4. System (1) according to claim 3, **characterized in that** the respective inner faces (3b, 7b) of the front and rear walls (3, 7) each have an opening (26, 27) for the passage of at least some of the front and rear connection cables (18, 19) from the front wall (3) toward the rear wall (7), and vice versa.

5. System (1) according to any of claims 1 to 4, **characterized in that** the outer face (7a) of the rear wall (7) comprises at least two rear connection means (8) interconnected by all or some of rear connection cables (19) on the side of the inner face (7b) of the rear wall (7).

6. System (1) according to any of claims 1 to 5, **characterized in that** the front connection means (4, 5) comprise one or more connectors (4, 5) intended to allow the connection of an electronic board by means of plugging in, and **in that** the outer face (3a) of the front wall (3) is provided with guide means (22 to 25) intended to guide the plugging in of the electronic board into the connector(s) (4, 5).

7. System (1) according to any of claims 1 to 5, **characterized in that** the rear connection means (8) comprise one or more connectors (4, 5) intended to allow the connection of an electronic board by plugging in, and **in that** the outer face (7a) of the rear wall (7) is provided with guide means (22 to 25) intended to guide the plugging in of the electronic board into the connector(s) (4, 5).

8. System (1) according to any of claims 1 to 7, **characterized in that** the fixing means (10 to 17) comprise one or more first fixing elements (10 to 13) arranged on the inner face (3b) of the front wall (3) and one or more second fixing elements (14 to 17) arranged on the inner face (7b) of the rear wall (7), the first fixing elements (10 to 13) being able to interact with the second fixing elements (14 to 17) in order to ensure that the front wall (3) is temporarily secured to the rear wall (7).

9. System (1) according to any of claims 1 to 8, **characterized in that** the front wall (3) and the rear wall (7) each have a larger dimension, the larger dimension of one of the front wall (3) and rear wall (7), or larger wall (3, 7), being greater than the larger dimension of the other of the front wall (3) and rear wall (7), or smaller wall (7, 3).

10. System according to claim 9, **characterized in that** it comprises a first and a second clamp (20, 21) which are fixed to the larger wall (3, 7) opposite one another along the larger dimension of this larger wall (3, 7), the first and second clamps (20, 21) being configured to protrude from the larger wall (3, 7) so as to each have a clamping portion (20a, 21a) extending, respectively, above two clamping zones of the smaller wall (7, 3) opposite one another along the larger dimension of this smaller wall (7, 3).

11. System (1) according to claim 10, **characterized in that** the clamping portion (20a, 21a) of at least one of the first and second clamps (20, 21) is provided with one or more studs, and **in that** the corresponding clamping zone of the smaller wall (7, 3) is provided with one or more cutouts, said studs being able to penetrate into said cutouts.

12. System (1) according to claim 10, **characterized in that** the clamping portion (20a, 21a) of at least one of the first and second clamps (20, 21) is provided with one or more cutouts (28, 29), and **in that** the corresponding clamping zone of the smaller wall (7, 3) is provided with one or more studs, said studs being able to penetrate into said cutouts (28, 29).

13. Computer cabinet (2a, 2b) intended to integrate a plurality of interconnected electronic boards and comprising at least one interconnecting system (1) according to any of the preceding claims.

14. Cabinet (2a, 2b) according to the preceding claim, **characterized in that** it has two side walls (2a, 2b) spaced by a given distance, the interconnecting system (1) being mounted inside the cabinet (2) such that said system extends between the two side walls (2a, 2b) along a determined dimension of the interconnecting system (1), said determined dimension being less than said given distance, the interconnecting system (1) being fixed to the side walls (2a, 2b) by means of lateral adjustment elements (30 to 33).
